# EUROPÄISCHE PATENTSCHRIFT

(11) **EP 3 650 879 B1**
(45) Veröffentlichungstag und Bekanntmachung des Hinweises auf die Patenterteilung: **15.05.2024**
(21) Anmeldenummer: 18204577.3
(22) Anmeldetag: 06.11.2018
(51) Int. Cl.: G01R 33/38, G01R 33/3815, G01R 33/385

(54) **ÜBERWACHUNG EINES MR-MAGNETEN ANHAND VON VIBRATIONEN**
MONITORING AN MR MAGNET BASED ON VIBRATIONS
SURVEILLANCE D'UN AIMANT MR EN FONCTION DES VIBRATIONS

(43) Veröffentlichungstag der Anmeldung: 13.05.2020
(73) Patentinhaber: Siemens Healthineers AG, 91301 Forchheim (DE)
(72) Erfinder: Dietz, Peter, 90762 Fürth (DE); Krug, Andreas, 90762 Fürth (DE); Ströhlein, Christopher, 90471 Nürnberg (DE); Wicklow, Karsten, 96049 Bamberg (DE)
(74) Vertreter: Siemens Healthineers Patent Attorneys

(56) Entgegenhaltungen:
- DE-A1-102010 041 146
- US-A1- 2004 032 260
- US-A1- 2007 182 516
- US-A1- 2015 369 888
- LONGZHI JIANG ET AL.: "Experimental Investigations on Gradient Coil Induced Magnet Heating in MRI System", INTERNATIONAL SOCIETY FOR MAGNETIC RESONANCE IN MEDICINE, ISMRM, 2030 ADDISON STREET, 7TH FLOOR, BERKELEY, CA 94704 USA, Bd. 22, Nr. 4846, 28. April 2014 (2014-04-28), XP040671619,
- YIHE HUA: "Gradient Coil Induced Joule Heating in a MRI magnet", INTERNATIONAL SOCIETY FOR MAGNETIC RESONANCE IN MEDICINE, Bd. 20, Nr. 2580, 1. April 2012 (2012-04-01), XP040625002,

## Beschreibung

Die vorliegende Erfindung betrifft ein Verfahren zum Überwachen eines Betriebsparameters für eine Magneteinrichtung eines Magnetresonanzsystems, wobei sich die Magneteinrichtung in einem Außengehäusen und einem darin liegenden Innengehäuse befindet. Darüber hinaus betrifft die vorliegende Erfindung ein Magnetresonanzsystem mit einem Außengehäuse, einem Innengehäuse innerhalb des Außengehäuses, einer Magneteinrichtung innerhalb des Innengehäuses und einer Gradientenspule außerhalb des Außengehäuses.

Bei Magnetresonanzsystemen wird ein Messobjekt einem starken, konstanten Magnetfeld (Grundmagnetfeld) ausgesetzt, um eine Ausrichtung der Kernspins der Atome im Messobjekt zu erreichen. Mit Hilfe von eingestrahlten Hochfrequenzwellen können "geordnete" beziehungsweise ausgerichtete Kernspins zu einer Schwingung (Resonanzfrequenz) angeregt werden. Durch die Schwingung wird ein hochfrequentes Antwortsignal angeregt, das mit Hilfe einer Empfangsspule zur späteren Analyse aufgenommen wird.

Für die Bildrekonstruktion ist eine exakte Information über den jeweiligen Entstehungsort (Ortsinformation) des HF-Antwortsignals eine zwingende Voraussetzung. Diese Ortsinformation wird durch magnetische Zusatzfelder (magnetische Gradientenfelder) zum statischen Magnetfeld entlang der drei Raumrichtungen gewonnen. Die Gradientenfelder sind im Vergleich zum Hauptfeld klein und werden durch Gradientenspulen gebildet.

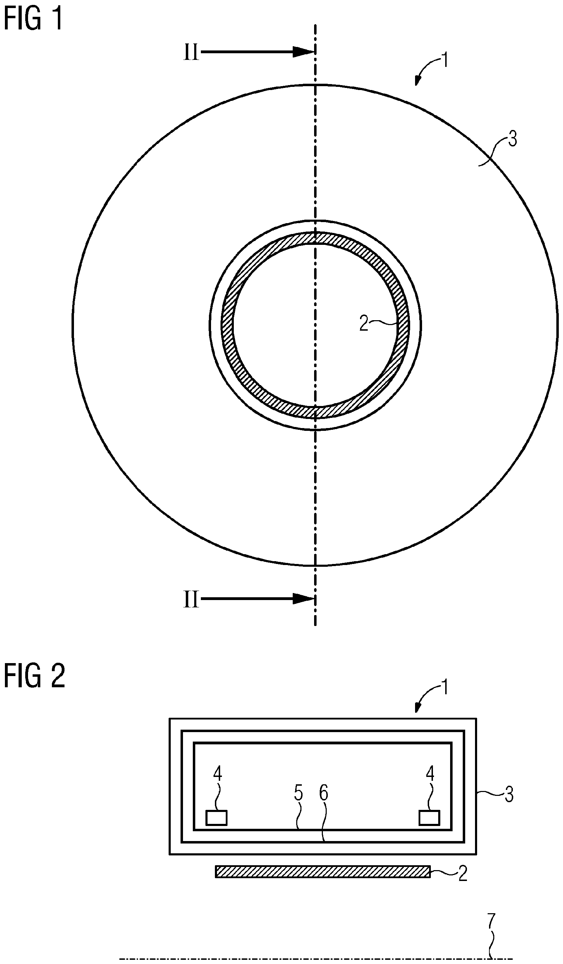

FIG 1 zeigt eine Frontansicht eines MR-Systems in prinzipieller Darstellung. Die Hauptkomponenten sind ein ringförmiger Grundfeldmagnet 1 und eine ebenfalls ringförmige Gradientenspule 2, die sich innerhalb des Innenumfangs des Grundfeldmagneten 1 befindet. In dieser Frontansicht ist neben der Gradientenspule 2 nur ein Außengehäuse 3 des Grundfeldmagneten 1 zu erkennen.

FIG 2 zeigt eine obere Hälfte des in FIG 1 angedeuteten Querschnitts durch das Magnetresonanzsystem. Der Grundfeldmagnet des Magnetresonanzsystems weist supraleitende Spulen 4 auf, die zur Kühlung in einem abgeschlossenen Behälter, der im vorliegenden Dokument auch als Heliumkessel oder Innengehäuse 5 bezeichnet wird, mit z.B. flüssigem Helium, angeordnet sind.

Der Heliumkessel beziehungsweise das Innengehäuse 5 ist von einem weiteren Behälter, der hier auch als Außengehäuse 3 bezeichnet wird, umgeben. Dieses Außengehäuse kann beispielsweise kesselförmig gestaltet und aus Edelstahl gefertigt sein. Es wird häufig auch als so genannte "Outer vacuum chamber" (OVC) bezeichnet.

Zwischen dem Außengehäuse 3 und dem meist mit flüssigem Helium, das sich typischerweise auf einer Temperatur von 4K befindet, gefüllten Innengehäuse 5 herrscht in der Regel Vakuum. Zusätzlich ist vielfach zwischen dem Außengehäuse 3 und dem mit flüssigem Helium gefüllten Innengehäuse 5 (mindestens) ein so genanntes Kryoschild beziehungsweise Kälteschild angeordnet, das hier auch als Zwischengehäuse 6 bezeichnet wird. Es dient zur Reduktion von Wärmestrahlung zwischen Au-ßengehäuse 3 und Innengehäuse 5. Andererseits werden bei einem aus elektrisch leitfähigem Material bestehendem Außengehäuse 3 aufgrund der Leitfähigkeit Einwirkungen von Gradientenspulen-Streufeldern auf den "Kryoschild" beziehungsweise das Zwischengehäuse 6 reduziert.

Mittels Tragelementen, die in FIG 2 nicht eingezeichnet sind, ist die ring- beziehungsweise zylinderförmige Gradientenspule 2 im Innenraum des Grundfeldmagneten 1 konzentrisch eingesetzt. Dabei ist die Gradientenspule 2 beispielsweise auf einem Tragrohr befestigt, welches der Übersicht halber in FIG 2 ebenfalls nicht eingezeichnet ist. Eine Mittelachse 7 des Systems stellt dessen Rotationssymmetrieachse dar. Etwa auf dieser Mittelachse 7 wird ein zu untersuchender Patient platziert.

Beim Betrieb der Gradientenspule 2 wird das Gehäuse 3, 5, 6 der Magneteinrichtung, d.h. des Grundfeldmagneten 1, einem zeitlich veränderlichen Streufeld ausgesetzt. Dadurch werden in den leitfähigen Schichten des Gehäuses 3, 5, 6 Wirbelströme induziert, die wiederum dazu führen, dass das Streufeld in Richtung des Heliumkessels beziehungsweise Innengehäuses 5, d.h. in Richtung der supraleitenden Spulen 4 transportiert wird. Der in diesem Heliumkessel beziehungsweise in den leitfähigen Strukturen wie supraleitenden Spulen 4 induzierte Wirbelstrom wird einerseits in ohmsche Wärme umgesetzt, was wiederum zum Erwärmen und zum Abdampf des flüssigen Heliums führen kann. Andererseits kann ein entsprechend starkes Streufeld auch in Richtung der supraleitenden Magnetspulen transportiert und zum Quench des Magneten (Übergang vom supraleitenden in den normal leitenden Zustand) führen. Diese dargestellten Transportprozesse des Streufelds der Gradientenspule in Richtung Heliumkessel 5 beziehungsweise Magnetspulen 4 wird überhöht, wenn das Streufeld mechanische Resonanzen der Schilde beziehungsweise Einzelgehäuse 3, 5, 6 der Magneteinrichtung 1 (Grundfeldmagnet) trifft. Prinzipiell wird das Problem bei höheren Grundfeldstärken verstärkt. Da die ohmsche Wärme ein Energiewert ist, ist dieser proportional zum Quadrat der entsprechenden Feldgröße. Der Zusammenhang zwischen dem Wirbelfeld am Ort der Magnetspulen und der Bewegung des Außengehäuses 3 wiederum ist linear.

Bisher wurde ein hoher Heliumverbrauch teilweise als notwendiges Übel akzeptiert. Sofern die Problematik bekannt war, wurde durch gezielte Modifikation der MR-Messsequenzen versucht, den Abdampf zu minimieren. Das Problem des Feldeintrags in Magnetspulen und eines dadurch induzierten Quench ist bislang ungelöst. Insbesondere war bislang keine Sensorik bekannt, deren Messwerte einen Magneten sicher vor zu hohem Energieeintrag schützen könnten. Temperatursensoren (abhängig von der Platzierung) und spezielle Drucksensoren haben relativ lange Zeitkonstanten, wohingegen ein Quench sehr schnell z.B. durch lokale Überhitzung ausgelöst werden kann.

Dokument US 2004/0032260 A1 beschreibt ein Verfahren zur Kompensation von Vibrationen in einem MRT-Apparat. Dabei werden Vibrationen eines Kryostaten gemessen und mit einer Übertragungsfunktion auf das Magnetfeld umgerechnet. Die Spulen werden entsprechend zur Kompensation der Vibrationen angesteuert.

Dokument US 2007/0182516 A1 ein MR-Gerät mit aktiver Abschirmung. Dadurch werden die von Wirbelströmen hervorgerufenen Vibrationen reduziert. Hierzu werden Übertragungsfunktionen zwischen dem Gradientenspulenstrom bzw. dem Abschirmstrom und den Vibrationen genutzt.

Ferner offenbart Dokument DE 10 2010 041 146 A1 eine Verbesserung der Patientenkommunikation in einem MRT. Um den Störgeräuschanteil zu reduzieren, werden die Gradientenströme gemessen und modellbasiert für jeden Gradientenstrom individuell entsprechende Störgeräuschanteile geschätzt.

Der Artikel LONGZHI JIANG ET AL.: "Experimental Investigations on Gradient Coil Induced Magnet Heating in MRI Systems", INTERNATIONAL SOCIENTY FOR MAGNETIC RESONANCE IN DEDICINE; ISMRM; 2030 Addison Street, 4th floor, Berkeley, CA 94704 USA; Bd. 22, Nr. 4846, 28. April 2014 beschreibt die durch Gradientenspulen induzierte Erwärmung eines Magneten eines MR-Systems. Dabei wird die Erwärmung des Magneten in Abhängigkeit von der Frequenz der Gradientenspulenerregung gemessen und simuliert.

Dokument US 2015/0369888 A1 offenbart ebenfalls ein Verfahren zum Reduzieren von Vibrationen in einem MR-System. Mit Elementen zur aktiven Kraftübertragung wird den Vibrationen entgegen gewirkt.

Der Artikel YIHE HUA: " Gradient Coil Induced Joule Heating in a MRI Magnet", INTERNATIONAL SOCIETY FOR MAGNETIC RESONANCE IN MEDICINE; Bd. 20, Nr. 2580, 1. April 2012 beschreibt die Joulsche Erwärmung eines MR-Magneten induziert durch Gradientenspulen. Die für die Erwärmung verantwortlichen Vibrationsspitzen können durch Spulenoptimierung reduziert werden.

Die Aufgabe der vorliegenden Erfindung besteht somit darin, ein Magnetresonanzsystem einfach und zuverlässig überwachen zu können und insbesondere eine Überhitzung von Komponenten einer supraleitenden Magneteinrichtung eines Magnetresonanzsystems zuverlässiger zu vermeiden.

Erfindungsgemäß wird diese Aufgabe durch ein Verfahren beziehungsweise ein Magnetresonanzsystem entsprechend den unabhängigen Patentansprüchen gelöst. Vorteilhafte Weiterbildungen der Erfindung ergeben sich aus den abhängigen Patentansprüchen.

Es wird demnach ein Verfahren gemäß Anspruch 1 zum Überwachen eines Betriebsparameters für ein Magnetresonanzsystem umfassend ein Außengehäuse bereitgestellt, wobei sich eine elektrisch leitfähige Struktur in dem Außengehäuse befindet und die leitfähige Struktur eine Magneteinrichtung oder ein Innengehäuse (5) ist, unter anderem durch
- Ermitteln eines Werts einer Vibrationsamplitude des Au-ßengehäuses oder eines in dem Außengehäuse liegenden Zwischengehäuses bei einer Vibrationsfrequenz,
- Bereitstellen eines Übertragungsverhältnisses zwischen der Vibrationsamplitude und dem Betriebsparameter bei der Vibrationsfrequenz und
- Ermitteln eines Werts des Betriebsparameters in Abhängigkeit von dem ermittelten Wert der Vibrationsamplitude mittels des Übertragungsverhältnisses wobei der Betriebsparameter entsprechend eine Temperatur des Innengehäuses (5), einen Druck im Innengehäuse (5), einen Energieeintrag in das Innengehäuse (5) oder in die Magneteinrichtung, oder eine von diesen abhängige Größe betrifft.

Erfindungsgemäß erfolgt das Ermitteln des Werts der Vibrationsamplitude (va) im Rahmen eines Ermittelns eines Vibrationsspektrums (18) über mehreren Vibrationsfrequenzen (f), das Bereitstellen des Übertragungsverhältnisses (u) im Rahmen eines Bereitstellens einer Übertragungsfunktion (17) des Betriebsparameters über der Vibrationsfrequenz (f), und das Ermitteln des Werts des Betriebsparameters in Abhängigkeit von dem ermittelten Vibrationsspektrum (18) mittels der Übertragungsfunktion (17, u).

Es wird also ein Betriebsparameter für ein Magnetresonanzsystem, insbesondere für eine Magneteinrichtung des Magnetresonanzsystems, überwacht. Bei der Magneteinrichtung handelt es sich um eine Einrichtung, die den Grundfeldmagneten für das Magnetresonanzsystem wie etwa supraleitende Spulen und gegebenenfalls dazugehörige Komponenten wie etwa flüssiges Helium umfasst. Der Betriebsparameter betrifft den Betrieb der Magneteinrichtung gegebenenfalls direkt oder indirekt. Die Magneteinrichtung kann sich in einem mehrschichtigen Gehäusesystem befinden, das mindestens ein Außengehäuse und ein Innengehäuse, unter Umständen auch ein oder mehrere Zwischengehäuse, aufweist. Die zwei oder mehr Einzelgehäuse liegen ineinander. Jedenfalls befindet sich in dem Außengehäuse eine leitfähige Struktur, die die Magneteinrichtung oder das Innengehäuse sein kann. Im Rahmen des Verfahrens erfolgt zunächst ein Messen einer Vibration, d.h. eines Vibrationswerts der Vibration des Außengehäuses oder eines Zwischengehäuses. Das Außengehäuse ist leicht zugänglich und das Zwischengehäuse zumindest leichter zugänglich als das Innengehäuse.

In einem Verfahrensschritt wird ein Wert einer Vibrationsamplitude des Außengehäuses oder eines zwischen dem Innengehäuse und dem Außengehäuse liegenden Zwischengehäuses bei einer Vibrationsfrequenz ermittelt. Gegebenenfalls werden auch mehrere Vibrationsamplituden insbesondere an unterschiedlichen Orten des jeweiligen Gehäuses gemessen.

Als weiterer Verfahrensschritt wird ein Übertragungsverhältnis zwischen der Vibrationsamplitude und dem Betriebsparameter bei der Vibrationsfrequenz bereitgestellt. In der Regel wird eine Gradientenspule mit Impulsen angesteuert, wodurch sich gegebenenfalls ortsabhängig an dem Außengehäuse und/oder dem Zwischengehäuse ein jeweiliges Vibrationsspektrum einstellt. Ein oder mehrere Zeitsignale derartiger komplexer Vibrationen können dann für das Magnetresonanzsystem gemessen werden, ebenso wie der korrespondierende Betriebsparameter (z.B. der Energieeintrag bei dieser Vibration in das Innengehäuse oder allgemein in die elektrisch leitfähige Struktur). Aus diesen beispielsweise vor dem Betrieb des Magnetresonanzsystems gemessenen Größen kann nun das Übertragungsverhältnis zwischen der Vibration und dem Betriebsparameter ermittelt werden. Gegebenenfalls muss das Übertragungsverhältnis nicht individuell für ein Magnetresonanzsystem bestimmt werden. Vielmehr kann für einen Typ eines Magnetresonanzsystems auch ein Übertragungsverhältnis vorab festgelegt sein. In diesem Fall genügt es, wenn das Übertragungsverhältnis beispielsweise in einem Speicher bereitgestellt wird, ohne dass es individuell bestimmt wurde.

In einem abschließenden Verfahrensschritt wird ein Wert des Betriebsparameters in Abhängigkeit von dem ermittelten Wert der Vibrationsamplitude mittels des Übertragungsverhältnisses ermittelt. In aller Regel wird dazu der Vibrationsamplitudenwert bei der jeweiligen Frequenz mit dem Übertragungsverhältnis multipliziert. Als Produkt ergibt sich ein Wert des Betriebsparameters, z.B. ein Wert für den Energieeintrag in die leitfähige Struktur, insbesondere in das Innengehäuse oder in eine supraleitende Spule. In vorteilhafter Weise ist es also nicht notwendig, den Betriebsparameter unmittelbar selbst zu messen, sondern es ist möglich, den Betriebsparameter indirekt über eine Vibration des Außengehäuses oder des Zwischengehäuses zu bestimmen. Dies kann mit einer Sensorik erfolgen, die leichter zugänglich beziehungsweise leichter austauschbar ist.

Erfindungsgemäß erfolgt das Ermitteln des Werts der Vibrationsamplitude im Rahmen eines Ermittelns eines Vibrationsspektrums über mehreren Vibrationsfrequenzen, das Bereitstellen des Übertragungsverhältnisses im Rahmen eines Bereitstellens einer Übertragungsfunktion des Betriebsparameters über der Vibrationsfrequenz und das Ermitteln des Werts des Betriebsparameters in Abhängigkeit von dem ermittelten Vibrationsspektrum mittels der Übertragungsfunktion. Es wird also nicht punktuell eine Vibrationsamplitude und ein Übertragungsverhältnis über einer einzigen Vibrationsfrequenz ermittelt, sondern vielmehr ein Vibrationsspektrum und eine korrespondierende Übertragungsfunktion über einem gewissen Spektralbereich von Vibrationsfrequenzen. Mit anderen Worten werden in Abhängigkeit von der Vibrationsfrequenz viele Übertragungsverhältnisse gewonnen, die zusammen die Übertragungsfunktion ergeben. Somit lassen sich viele Spektralanteile z.B. für den Energieeintrag in den Heliumkessel ermitteln und diese Spektralanteile lassen sich zu einem Gesamtwert des Betriebsparameters (z.B. Gesamtenergieeintrag) aufsummieren.

Erfindungsgemäß handelt es sich bei der leitfähigen Struktur um eine Magneteinrichtung, insbesondere eine supraleitende Spule, oder um ein Innengehäuse, und der Betriebsparameter betrifft entsprechend eine Temperatur des Innengehäuses, einem Druck im Innengehäuse, einem Energieeintrag in das Innengehäuse oder in die Magneteinrichtung, oder eine von diesen abhängige Größe. Der Betriebsparameter kann auch eine dieser Größen indirekt betreffen. Durch einen derartigen Temperaturwert, Druckwert, Energiewert oder dergleichen lassen sich die Verhältnisse im Innengehäuse insbesondere hinsichtlich eines Heliumabdampfens oder eines Quench der supraleitenden Magnetspulen gut abschätzen. Abhängig davon kann das Magnetresonanzsystem entsprechend gesteuert werden.

In bevorzugter Ausgestaltung kann das Bereitstellen des Übertragungsverhältnisses oder der Übertragungsfunktion dann beinhalten, dass vor Inbetriebnahme des Magnetresonanzsystems der Betriebsparameter bei der jeweiligen Vibrationsfrequenz gemessen oder simuliert wird. Dies bedeutet, dass vor dem eigentlichen Betrieb des Magnetresonanzsystems der Betriebsparameter, z.B. die Temperatur im Innengehäuse, zusammen mit der Vibration des Außengehäuses oder Zwischengehäuses bei einer oder bei unterschiedlichen Vibrationsfrequenzen gemessen wird. Es ergibt sich damit ein charakteristischer Zusammenhang zwischen den Vibrationen und dem Betriebsparameter, der den Zustand im Inneren des Magnetresonanzsystems kennzeichnet. Die jeweilige Vibrationsamplitude wird beispielsweise mit einem Schwingungssensor detektiert. Bei einer anderen Alternative des Bereitstellens des Übertragungsverhältnisses oder der Übertragungsfunktion wird der Zusammenhang zwischen der Vibration und dem Betriebsparameter in Abhängigkeit von der Frequenz simuliert. Dies bedarf genauerer Informationen über die physikalischen Zusammenhänge im Inneren der Magnetresonanzsystems. Durch die Simulation lassen sich aber aufwändige Messungen vermeiden.

In einer Ausführungsform des erfindungsgemäßen Verfahrens ist die Übertragungsfunktion bezüglich der Vibrationsfrequenz nicht-linear. Insbesondere ist die Übertragungsfunktion bezüglich der Vibrationsfrequenz nicht konstant. Es gibt also keinen direkten linearen Zusammenhang zwischen Vibrationsamplitude und Zielgröße, wie Energieeintrag etc. Vielmehr hängt die Übertragungsfunktion von dem speziellen Systemaufbau, von den verwendeten Materialien und sonstigen Zustandsvariablen des Systems ab. Es kann somit nicht ohne weiteres von der Frequenz auf die Übertragungsfunktion geschlossen werden. Vielmehr sind hierzu aufwändige Messungen beziehungsweise Simulationen notwendig.

Darüber hinaus kann vorgesehen sein, dass ein Signal der Vibration im Zeitbereich gemessen und zum Ermitteln des Vibrationsspektrums in den Frequenzbereich transformiert wird. Es wird also beispielsweise von einem Vibrationssensor ein zeitlich veränderliches Vibrationssignal gemessen. Insbesondere mit einer FFT (Fast Fourier Transformation) lässt sich dieses Zeitsignal in ein Frequenzsignal transformieren. Mit dem resultierenden Vibrationsspektrum erhält man die jeweilige Vibrationsamplitude in jedem Frequenzband.

Entsprechend einer weiteren Ausgestaltung ist vorgesehen, dass der ermittelte Wert des Betriebsparameters mit einem Schwellwert verglichen wird, und in Abhängigkeit von dem daraus resultierenden Vergleichsergebnis das Magnetresonanzsystem abgeschaltet wird. Es wird also hier zunächst anhand der Vibrationsfrequenz und dem Übertragungsverhältnis oder anhand des Vibrationsspektrums und der Übertragungsfunktion der gesuchte Wert des Betriebsparameters ermittelt. Falls nun dieser Wert einen vorgegebenen Schwellwert überschreitet, ist dies ein Zeichen für einen kritischen Zustand des Magnetresonanzsystems. Daher kann ein entsprechender Vergleich mit dem Schwellwert dazu genutzt werden, dass Magnetresonanzsystem abzuschalten. Erfindungsgemäß wird die oben genannte Aufgabe auch gelöst durch ein Magnetresonanzsystem gemäß Anspruch 6 mit
- einem Außengehäuse,
- einer elektrisch leitfähigen Struktur innerhalb des Au-ßengehäuses (3), wobei die leitfähige Struktur eine Magneteinrichtung oder ein Innengehäuse (5) ist, und
- einer Gradientenspule außerhalb des Außengehäuses, sowie umfassend unter anderem
- eine Sensoreinrichtung, die zum Ermitteln eines Werts einer Vibrationsamplitude des Außengehäuses oder eines in dem Außengehäuse liegenden Zwischengehäuses bei einer Vibrationsfrequenz konfiguriert ist und
- einer Überwachungseinrichtung, die zum Bereitstellen eines Übertragungsverhältnisses zwischen der Vibrationsamplitude und dem Betriebsparameter bei der Vibrationsfrequenz und zum Ermitteln eines Werts des Betriebsparameters in Abhängigkeit von dem ermittelten Wert der Vibrationsamplitude mittels des Übertragungsverhältnisses konfiguriert ist.

Die Sensoreinrichtung kann einen oder mehreren Sensoren aufweisen. Insbesondere können Beschleunigungswerte an dem Au-ßengehäuse und/oder dem Zwischengehäuse gemessen werden. Die Sensoreinrichtung kann auch Mittel zur Vorverarbeitung von Sensorsignalen aufweisen.

Erfindungsgemäß ist die elektrisch leitfähige Struktur ein Innengehäuse und/oder eine Magneteinrichtung, insbesondere eine oder mehrere supraleitende Spulen und gegebenenfalls Kühlmaterial, welches z.B. in das Innengehäuse oder ein Rohrsystem gefüllt ist.

Gegebenenfalls enthält die Magneteinrichtung auch Steuerelemente zum Steuern der elektrischen (supraleitenden) Magnete.

Die Überwachungseinrichtung kann einen Prozessor und insbesondere einen Mikroprozessor zur Datenverarbeitung aufweisen. Darüber hinaus kann sie auch Speicherelemente zum Speichern von Daten aufweisen. Insbesondere kann in den Speicherelementen ein Übertragungsverhältnis, beziehungsweise eine Übertragungsfunktion gespeichert werden.

Weitere Gestaltungsmöglichkeiten und Vorteile des Magnetresonanzsystems ergeben sich analog zu den oben geschilderten Variationsmöglichkeiten des Verfahrens zum Überwachen eines Betriebsparameters für das Magnetresonanzsystem.

Zwischen dem Außengehäuse und dem Innengehäuse des Magnetresonanzsystems kann nicht nur ein Zwischengehäuse, sondern mindestens ein weiteres Zwischengehäuse angeordnet sein. Derartige Zwischengehäuse dienen vorzugsweise als Kälte- beziehungsweise Kryoschilde. Mehrere derartige Kryoschilde haben den Vorteil, dass die Wärmestrahlung entsprechend besser vom Innengehäuse abgehalten werden kann.

Des Weiteren kann vorgesehen sein, dass die Sensoreinrichtung mindestens zwei Sensoren aufweist, die zwischen der Gradientenspule und dem Außengehäuse oder unmittelbar an der Gradientenspule angeordnet sind. Auf diese Weise kann gewährleistet werden, dass die durch das Gradientenfeld hervorgerufenen Vibrationen genauer detektiert werden können. Falls genügend Raum zwischen der Gradientenspule und dem Außengehäuse besteht, können die Sensoren dazwischen angeordnet werden. Falls dem nicht so ist, können die Sensoren auch am axialen Rand der Gradientenspule angeordnet werden.

Das Außengehäuse kann eine äußere Vakuumkammer darstellen. Dies bedeutet, dass sich im Inneren des Außengehäuses Vakuum befindet. Insbesondere kann das Vakuum zwischen dem Außengehäuse und dem Innengehäuse herrschen. Somit kann Wärmekonvektion wirkungsvoll unterbunden werden.

Wie oben bereits angedeutet wurde, kann das Zwischengehäuse und/oder das weitere Zwischengehäuse ein Kälteschild darstellen. Mit Hilfe dieser Zwischengehäuse beziehungsweise Kälteschilde lässt sich auch die Wärmestrahlung zwischen Innengehäuse und Außengehäuse unterbinden.

Die elektrisch leitfähige Struktur kann ein Innengehäuse und/oder eine Magneteinrichtung aufweisen. Das Innengehäuse des Magnetresonanzsystems kann wiederum eine Heliumkammer oder ein Rohrsystem darstellen. Die Magneteinrichtung ihrerseits kann eine oder mehrere supraleitende Spulen aufweisen. Speziell kann sich in der Heliumkammer flüssiges Helium zum Kühlen supraleitender Spulen der Magneteinrichtung auf etwa 4K befinden. Für andere Supraleiter kann das Innengehäuse auch mit einem anderen Kühlmittel gefüllt sein. Ist das Innengehäuse als Rohrsystem ausgebildet, so können Rohre des Rohrsystems entlang der supraleitenden Spulen, d.h. an diesen, verlaufen. Das Rohrsystem kann ein einziges Rohr oder mehrere Rohre besitzen. Das bzw. die Rohre führen dann das Kühlmittel zum Kühlen der angrenzenden bzw. benachbarten supraleitenden Spulen.

Bei einer speziellen Ausgestaltung des Magnetresonanzsystems, ist die Vibration des Zwischengehäuses oder Außengehäuses mit einer Vibration des Innengehäuses magneto-mechanisch fest gekoppelt. Diese Kopplung erfolgt also nicht rein mechanisch, sondern durch magneto-mechanische Wechselwirkung. Bei einer derartigen festen Kopplung kann direkt von der Vibration des Außengehäuses auf die Vibration des Innengehäuses geschlossen werden. Damit kann von der Vibration des Außengehäuses unmittelbar auf dem Energieeintrag in das Innengehäuse bzw. in die elektrisch leitfähige Struktur geschlossen werden.

Generell kann die Vibration des Zwischengehäuses oder Außengehäuses mit einer Vibration des Innengehäuses bzw. der elektrisch leitfähigen Struktur entsprechend dem Übertragungsverhältnis oder der Übertragungsfunktion gekoppelt sein. Mit anderen Worten beeinflusst die Kopplung zwischen Innengehäuse bzw. elektrisch leitfähiger Struktur und Außengehäuse das Übertragungsverhältnis beziehungsweise die Übertragungsfunktion.

Die oben beschriebenen Eigenschaften, Merkmale und Vorteile dieser Erfindung sowie die Art und Weise, wie dieser erreicht werden, werden klarer und deutlicher verständlich in Zusammenhang mit der folgenden Beschreibung der Ausführungsbeispiele, die in Zusammenhang mit den Zeichnungen näher erläutert werden. Durch diese Beschreibung erfolgt keine Beschränkung der Erfindung auf diese Ausführungsbeispiele. In verschiedenen Figuren sind gleiche Komponenten mit identischen Bezugszeichen verstehen. Die Figuren sind in der Regel nicht maßstäblich.

In den Zeichnungen zeigen:
- FIG 1: eine schematische Frontansicht eines Magnetresonanzsystems;
- FIG 2: einen Teilquerschnitt durch das Magnetresonanzsystem von FIG 1;
- FIG 3: eine Prinzipskizze zur Entstehung von primären Wirbelströmen;
- FIG 4: eine Prinzipskizze zum Einfluss des magnetischen Grundfelds;
- FIG 5: eine Prinzipskizze zur Entstehung sekundärer Wirbelströme;
- FIG 6: eine Prinzipskizze zur Entstehung sekundärer Felder;
- FIG 7: Gehäuseschichten bei vollständiger Kopplung;
- FIG 8: Gehäuseschichten bei loser Kopplung;
- FIG 9: eine Anordnung von Vibrationssensoren bei kleinem Spalt zwischen Außengehäuse und Gradientenspule;
- FIG 10: eine Anordnung von Vibrationssensoren bei größerem Spalt zwischen Außengehäuse und Gradientenspule;
- FIG 11: eine schematische Übertragungsfunktion;
- FIG 12: ein Vibrationsspektrum; und
- FIG 13: einen beispielhaften, schematischen Verfahrensab-lauf.

Die nachfolgend näher geschilderten Ausführungsbeispiele stellen bevorzugte Ausführungsformen der vorliegenden Erfindung dar.

Wie einleitend bereits erwähnt wurde, wird beim Betrieb einer Gradientenspule 2 (vergleiche FIG 2) eines Magnetresonanzsystems das Gehäuse 3, 5, 6 des Magneten einem zeitlich veränderlichen Streufeld ausgesetzt. Dadurch werden in den leitfähigen Schichten des Magnetgehäuses Wirbelströme induziert, die wiederum dazu führen, dass das Streufeld in Richtung des Heliumkessels oder eines entsprechenden Rohrsystems, d.h. des Innengehäuses 5, beziehungsweise in Richtung der Magnetspulen 4 transportiert wird (nachfolgend werden stellvertretend für elektrisch leitfähige Strukturen im Außengehäuse 3 meist nur das Innengehäuse 5 oder die Magnetspulen genannt, aber es kann sich auch um andere Leitungsabschnitte, Anschlüsse, Armaturen oder dergleichen handeln). Der in diesem Heliumkessel (nachfolgend wird dieser Begriff häufig stellvertretend für das Innengehäuse 5 oder auch Rohrsystem verwendet) oder in den anderen leitfähigen Strukturen wie Magnetspulen 4, 4K-Schild (nachfolgend stellvertretend für den Begriff Zwischengehäuse 6 benutzt) etc. induzierte Wirbelstrom wird einerseits in ohmsche Wärme umgesetzt, was wiederum zum Erwärmen und zum Abdampfen des flüssigen Heliums führen kann. Andererseits kann ein entsprechend starkes Streufeld auch in Richtung der supraleitenden Magnetspulen 4 transportiert und zum Quench des Magneten führen. Diese Transportprozesse des Streufelds der Gradientenspule 2 in Richtung Heliumkessel 5 beziehungsweise Magnetspulen 4 wird überhöht, wenn das Streufeld mechanische Resonanzen der Schilde beziehungsweise Einzelgehäuse 3, 5, 6 im Magnetgehäuse trifft. Prinzipiell wird das Problem bei höheren Grundfeldstärken verstärkt. Da die ohmsche Wärme ein Energiewert ist, ist dieser proportional zum Quadrat der Feldgrößen. Der Zusammenhang zwischen dem Wirbelfeld am Ort der Magnetspulen und der Bewegung des OVC 3 ("outer vacuum chamber"; nachfolgend auch stellvertretend für den Begriff Außengehäuse 3 verwendet) ist in der Regel linear.

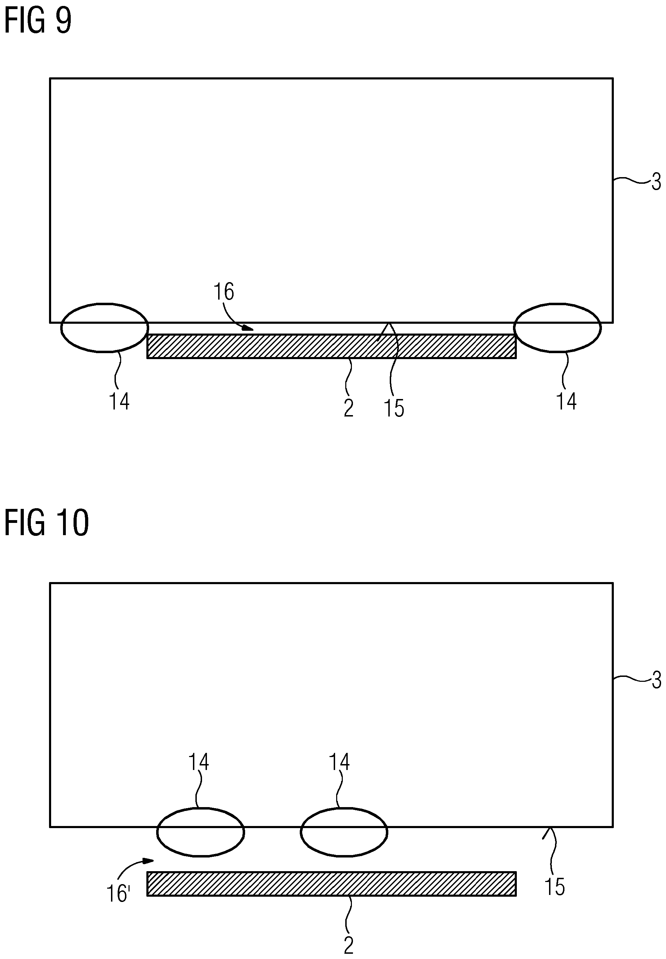

Um den Heliumverbrauch zu minimieren, konnten bislang nur gezielte Modifikationen der MR-Messsequenzen vorgenommen werden. Im Ausnahmefall war ein Feldeintrag in die Magnetspulen und ein dadurch induzierter Quench des Magneten kaum beherrschbar. Eine Sensorik, die in der Lage ist, rasch z.B. eine lokale Überhitzung zu detektieren, ist nicht bekannt. Da sowohl der beziehungsweise die Kälteschilde 6 und der Heliumkessel 5 aufgrund der Kryogenik nur schwer zugänglich sind, ist es schwierig, die Vibration, beziehungsweise die eingebrachte Wärme in diesen Strukturen direkt während der Bildgebung des Magnetresonanzsystems zu messen. Da das Außengehäuse 3 des Magneten (d.h. das OVC) in der Regel ebenfalls leitfähig ist, nimmt auch diese Struktur an dem genannten Transport des Feldes in Richtung Heliumkessel 5 teil. Auf dieser Erkenntnis beruhend wird daher erfindungsgemäß vorgeschlagen, zum Bestimmen des Energieeintrags in den Heliumkessel 5 die Vibrationen des OVC 3 zu messen. Dafür sollten an klar definierten Positionen (insbesondere Positionen, die der Symmetrie des Gradientenfelds und somit auch des Streufelds der Gradientenspule Rechnung tragen) im so genannten "Innenbore", d.h. dem Innenumfang bzw. der Innenseite des ringförmigen Außengehäuses und auf den Enden des OVC 3 Vibrationssensoren angebracht werden (vergleiche FIG 9 und 10). Anstelle des Energieeintrags in das Innengehäuse kann beispielsweise auch ein anderer Betriebsparameter, nämlich eine Temperatur des Innengehäuses, ein Druck im Innengehäuse oder eine von diesen abhängige Größe indirekt über die Vibration des OVC 3 oder eines Kälteschilds 6 bestimmt werden.

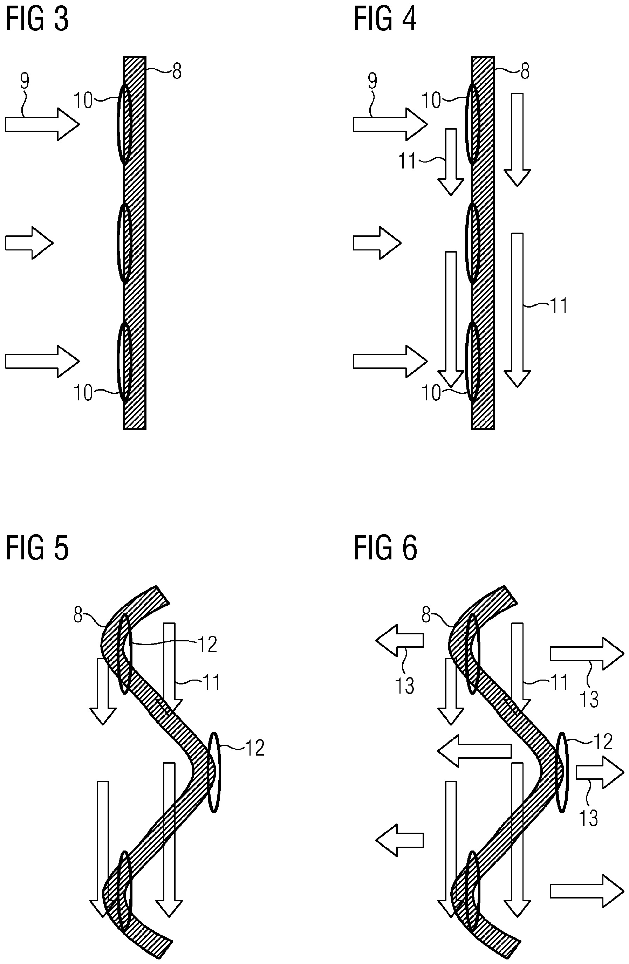

Der Zusammenhang zwischen diesem kritischen Betriebsparameter und der Vibration des OVC beziehungsweise Außengehäuses 3 basiert auf Kenntnissen, die in Zusammenhang mit den FIG 3 bis 8 kurz erläutert werden. Insbesondere wird hierdurch der Transport der Felder bzw. der Energie durch die Gehäuseschichten erklärt.

FIG 3 zeigt eine Gehäusewand 8, die Teil des Außengehäuses 3, der Innengehäuses 5 oder eines Zwischengehäuses 6 des Magnetresonanzsystems sein kann (vergleiche FIG 2). Ein dynamisches Streufeld 9 der Gradientenspule 2 wirkt insbesondere senkrecht auf die leitfähige Wand 8. Dadurch werden in der leitfähigen Wand 8 primäre Wirbelströme 10 induziert.

Zusätzlich wirkt gemäß FIG 4 parallel zu der Wand und im Wesentlichen senkrecht zu dem dynamischen Streufeld 9 das Grundfeld beziehungsweise B₀-Feld 11. Durch die resultierenden Lorenzkräfte wird die Wand 8 ausgelenkt und schwingt in Abhängigkeit von der Dynamik des Gradientenfelds bzw. Streufelds 9. Dies ist in FIG 5 skizziert, wobei der Übersicht halber das Streufeld 9 nicht mehr eingezeichnet ist. Aufgrund dieser Schwingungen der Wand 8 entstehen sekundäre Wirbelströme 12. Diese wiederum sorgen gemäß FIG 6 für sekundäre Felder 13 senkrecht zu dem B₀-Feld 11. Diese sekundären Felder 13 wirken auch auf das jeweils benachbarte Gehäuse und regen auch diese zu entsprechenden Schwingungen an. Somit können Felder durch die einzelnen leitfähigen Gehäuse transportiert werden. Folglich entstehen auch entsprechende Wirbelströme im Innengehäuse, das z.B. mit Helium gefüllt ist. Ebenso können sich die Felder bis zu den Magnetspulen fortsetzen und auch dort entsprechende Wirbelströme hervorrufen. Die oben geschilderten Energieeinträge mit den entsprechenden Konsequenzen sind die Folge.

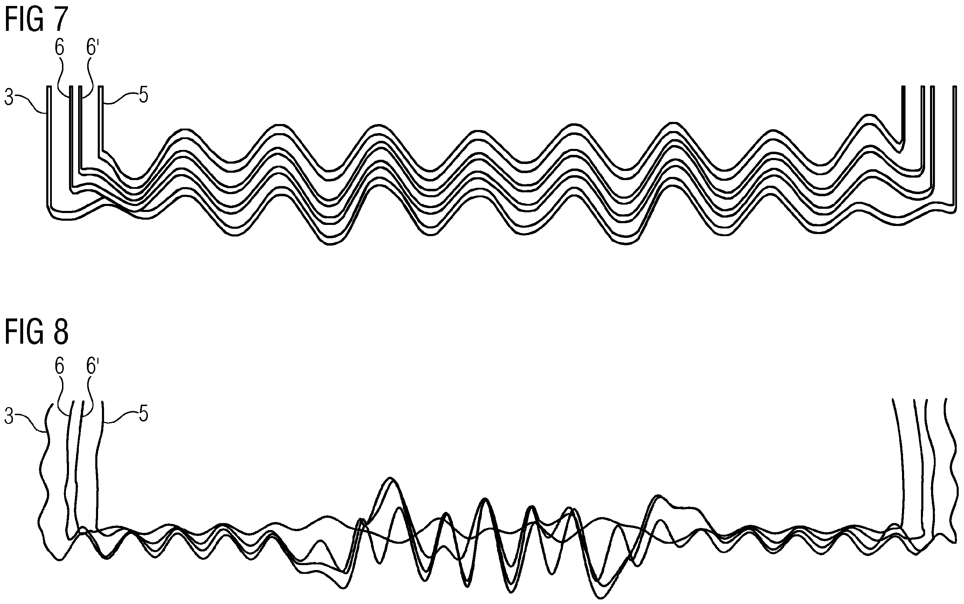

FIG 7 zeigt einen Schnitt durch einen Teil eines vierwandigen Magnetgehäuses, z.B. im Bereich des Innenbore. Die Einzelgehäuse von außen nach innen sind: das Außengehäuse 3, ein erstes Zwischengehäuse 6, ein zweites Zwischengehäuse 6' und das Innengehäuse 5. In der FIG 7 ist zu erkennen, dass sämtliche Einzelgehäuse 3, 6, 6` und 5 gleichförmig beziehungsweise synchron schwingen. Wenn also das Außengehäuse 3 einen Wellenbauch nach außen besitzt, besitzen auch die Zwischengehäuse 6 und 6` sowie das Innengehäuse 5 an der korrespondierenden Stelle einen Wellenbauch nach außen. Gleiches gilt für die anderen Schwingungsphasen. In diesem Fall herrscht also eine feste beziehungsweise vollständige Kopplung zwischen den Einzelgehäusen. Es liegt eine eindeutige Korrelation zwischen den äußeren und inneren Schwingungen vor.

FIG 8 zeigt hingegen einen Fall, bei dem keine vollständige Kopplung zwischen den Einzelgehäusen vorliegt. An dieser Stelle sei betont, dass die Zeichnung nicht maßstabsgetreu ist und insbesondere auch der Abstand zwischen den Einzelgehäusen verkleinert dargestellt wurde, um den Effekt besser erkennen zu können. Insbesondere zeigt sich, dass die Schwingungen der Einzelgehäuse zumindest teilweise vollständig unkorreliert sind. Mit anderen Worten, das Außengehäuse 3 schwingt anders als das Innengehäuse 5. Während also bei dem System von FIG 7 unmittelbar von der Schwingung des Außengehäuses 3 auf die Schwingung des Innengehäuses 5 geschlossen werden kann, ist dies bei dem System von FIG 8 nicht möglich. Vielmehr ist dort davon auszugehen, dass sich die Kopplung zwischen Außengehäuse 3 und Innengehäuse 5 durch eine eher komplexe Übertragungsfunktion beschreiben lässt.

Um nun die Vibrationen des Außengehäuses 3 aufnehmen zu können, sind entsprechende Vibrationssensoren 14 z.B. am Außengehäuse 3 anzuordnen, wie dies beispielsweise FIG 9 zeigt. Die Komponenten im Inneren des Außengehäuses 3 sind im Gegensatz zu FIG 2 der Einfachheit halber nicht dargestellt. Das ringförmige Außengehäuse 3 besitzt eine Innenseite 15, die auch als Innenbore beziehungsweise Innenumfang bezeichnet werden kann. Zwischen der Innenseite 15 und der Gradientenspule 2 ist hier nur ein schmaler Spalt 16 vorgesehen. Dieser Spalt 16 genügt hier nicht, um die Vibrationssensoren 14 zwischen der Innenseite 15 und der Gradientenspule 2 anzuordnen. Daher werden die Vibrationssensoren 14 seitlich neben der Gradientenspule 2, möglichst nahe daran platziert an dem Au-ßengehäuse 3 befestigt. Die Vibrationssensoren 14 nehmen dann die Schwingungen von Gehäuseabschnitten auf, die nicht exakt von einem radialen Streufeld beeinflusst werden, aber durch die unmittelbare Nähe zu der Gradientenspule sind deren Auswirkungen immer noch gut erfassbar. Insbesondere pflanzen sich die Vibrationen des Außengehäuses 3 in axialer Richtung auch seitlich von der Gradientenspule fort. Auch mit derart etwas abseits platzierten Vibrationssensoren lassen sich aussagekräftige Abschätzungen des Energieeintrags in dem Heliumkessel 5 tätigen.

Bei einem anderen Aufbau des Magnetresonanzsystems gemäß FIG 10 besteht genügend Abstand 16' zwischen der Innenseite 15 und der Gradientenspule 2. In diesem Fall lassen sich die Vibrationssensoren 14 unmittelbar im Spalt 16' platzieren. Da das Gradientenfeld und somit auch das Streufeld der Gradientenspule 2 in der Regel symmetrisch ist, genügt es meist, einen Bruchteil der von den Vibrationen betroffenen Fläche des Außengehäuses 3 beziehungsweise Zwischengehäuses 6 mit Vibrationssensoren 14 auszustatten. Beispielsweise genügt es, ein Viertel oder ein Achtel der schwingenden Fläche des Außengehäuses 3 mit den Schwingungssensoren beziehungsweise Vibrationssensoren zu analysieren, um den Gesamteintrag an Energie in den Heliumkessel 5 zuverlässig abschätzen zu können. Bei den schematischen Zeichnungen von FIG 9 und FIG 10 ist jedoch zu beachten, dass die eingezeichneten Symbole für die Vibrationssensoren 14 lediglich mögliche Orte für die Vibrationssensoren darstellen. So können beispielsweise an der Innenseite 15 des Außengehäuses 3 verteilt 50 Sensoren oder eine beliebige andere Anzahl angeordnet sein, um die Schwingungen entsprechend auch lokal genau aufnehmen zu können.

Die kritische Größe, die zum Heliumabdampf oder Quench führen kann, wird im vorliegenden Dokument auch allgemein als Betriebsparameter bezeichnet. Wie oben bereits erwähnt wurde, kann es sich hierbei um die Temperatur des Innengehäuses, den Druck im Innengehäuse, den Energieeintrag in das Innengehäuse oder eine korrespondierende Größe handeln. Nachfolgend wird stellvertretend für andere Betriebsparameter meist von Energieeintrag gesprochen.

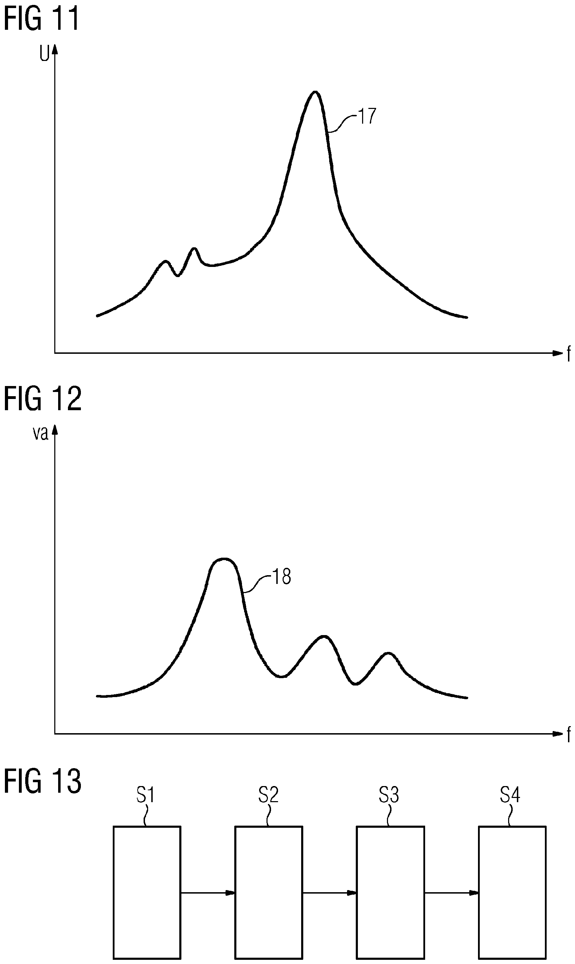

Da die Schwingungen des OVC 3 nicht direkt der gesuchten problematischen Größe (d.h. den Energieeintrag im kritischen Bereich des Magneten, beispielsweise im Heliumkessel 5) entsprechen, muss zunächst die Abhängigkeit der gesuchten Größe (Energie im Heliumkessel 5 beziehungsweise in der 4K-Struktur 6) von der gemessenen Größe (Vibrationen des OVC 3) ermittelt werden. Es sollte also eine Übertragungsfunktion zwischen den gemessenen Vibrationen und dem Energieeintrag im Heliumkessel 5 gebildet werden. Für vereinfachte Abschätzungen kann es auch genügen, anstelle einer Übertragungsfunktion über der Vibrationsfrequenz nur ein Übertragungsverhältnis bei einer bestimmten, markanten Vibrationsfrequenz zu bilden. Unter Umständen genügt es beispielsweise für eine grobe Schätzung, nur die Vibrationen bei 2000 Hz und den dortigen Übertragungsfaktor beziehungsweise das dortige Übertragungsverhältnis zu bestimmen, um den gesamten Energieeintrag zum jeweiligen Zeitpunkt zu schätzen. Wesentlich genauer ist es jedoch, eine exakte Übertragungsfunktion 17 über alle Vibrationsfrequenzen f spektral zu bestimmen (vergleiche FIG 11) und ebenso ein korrespondierendes Vibrationsspektrum 18 zu bestimmen (vergleiche FIG 12), um so für jedes Frequenzband den jeweiligen Energieeintrag zu ermitteln. Der Energieeintrag über sämtliche Frequenzbänder integriert ergibt dann die gesuchte Größe des gesamten Energieeintrags beziehungsweise des Werts der kritischen Größe.

Für die Ermittlung der Übertragungsfunktion 17 gemäß FIG 11 wird beispielsweise die Energie im Heliumkessel 5 (beziehungsweise in den kritischen Bereichen wie Magnetspulen, 4K-Schild 6) als Funktion der Anregungsfrequenz beziehungsweise Vibrationsfrequenz f gemessen. Hierzu wird beispielsweise ein Messwert für jedes Frequenzband einzeln ermittelt. Es ergibt sich beispielsweise eine Übertragungsfunktion 17 wie sie in FIG 11 dargestellt ist, die ein deutliches Maximum aufweist. Dieses Maximum kann beispielsweise systembedingt bei 2000 Hz liegen.

Da der Prozess des Feld- oder Energietransports ausgehend vom Streufeld der Gradientenspule bis zum Magnetinneren nur von dem Aufbau des Systems, d.h. der Geometrie des Magneten und der Gradientenspule, der Leitfähigkeit der verbauten Materialien, dem Streufeld der Gradientenspule und dem Magnetfeld des Hauptmagneten abhängt, genügt es, diese Messung einmalig durchzuführen. Daher muss dabei nicht darauf geachtet werden, dass das MR-System während dieser Messung alle Anforderungen erfüllt, die zur MR-Bildgebung nötig sind. D.h. es können für die genaue und gegebenenfalls langwierigen Aufnahme der Übertragungsfunktion 17, die das jeweilige frequenzabhängige Übertragungsverhältnis zeigt, Messmethoden eingesetzt werden, die entweder zu aufwändig sind, um sie während des normalen Betriebs laufen zu lassen, oder die das System so verändern, dass eine normale Bildgebung nicht eingeschränkt möglich ist. So können insbesondere zahlreiche Thermosensoren mit einer entsprechenden Anzahl von Kabeln, aber auch bestromte Hallsensoren eingesetzt werden, die nicht nur Bildstörungen hervorrufen würden, sondern auch einen entsprechend hohen Energieeintrag.

Die Messgröße zur Ermittlung der eingetragenen Energie ist dann beispielsweise die Wärme im Heliumkessel 5, das abgedampfte Helium, die Druckänderung im Heliumkessel oder eine entsprechend andere Größe. Misst man nun sowohl die entsprechende Kenngröße für den Energieeintrag im Heliumkessel 5 (z.B. abgedampftes Helium), als auch die jeweilige Vibrationsfrequenz f des OVC 3, so kann aus beiden Größen die Übertragungsfunktion 17 gemäß FIG 11 erzeugt werden. Damit kann man insbesondere bei einer bestimmten Frequenz des Gradientensignals für einen Wert der OVC-Vibrationsamplitude einen Wert des Energieeintrags im Heliumkessel 5 angeben. Diese Übertragungsfunktion wird für das System abgespeichert.

Sollte eine solche Messung nicht möglich sein, oder sollte eine Übertragungsfunktion für einen ähnlichen Typ des MR-Systems ermittelt werden, könnte die Übertragungsfunktion auch mit Hilfe einer Simulation ermittelt werden. In solch einer Simulation müsste der komplette Prozess (Transport des Felds von der Gradientenspule zum Magnetinneren über eine Kopplung von magnetischen Feldern und mechanischen Bewegungen) in dem relevanten Frequenzbereich berechnet werden.

Während des normalen Betriebs des MR-Systems genügt es dann, lediglich die Vibrationen des OVC 3 zu messen. Beispielsweise wird aus den gewonnenen Zeitsignalen mittels einer FFT ein Vibrationsspektrum gemäß FIG 12 gewonnen, welches die Vibrationsamplitude va über der Frequenz zeigt. Für jedes Frequenzband lässt sich dann die Vibrationsamplitude va mit dem jeweiligen Übertragungsverhältnis u der Übertragungsfunktion 17 multiplizieren, um den jeweiligen Energieeintrag pro Frequenzband zu ermitteln. Die Summe über alle Frequenzbänder ergibt dann den gesamten Energieeintrag beziehungsweise den gesuchten Wert des Betriebsparameters.

Es ist zu beachten, dass die Vibrationen und der Feldeintrag auf den Magnetspulen linear mit dem Streufeld skalieren, während der Energieeintrag quadratisch mit dem Feld skaliert. Dies bedeutet, dass für das Ermitteln des Einflusses auf den Energieeintrag in den Heliumkessel 5 die Vibrationsamplitude quadriert werden muss.

Bei Hochfeldsystemen, d.h. bei Feldstärken von 7 T und mehr, hat ein Vibrationsspektrum 18 des OVC 3 aufgrund der magnetischen Kopplungen starke Ähnlichkeiten mit dem Spektrum des Energieeintrags im Heliumkessel 5. Bei voll gekoppeltem Zustand (vergleiche FIG 7) kann abhängig von der Hardwarekonfiguration und dem Frequenzbereich die Amplitude des Vibrationsmesswerts direkt als Kenngröße verwendet werden.

Bei kleinen Systemen hingegen, d.h. bei niedrigeren Feldstärken (1,5 T und kleiner) sind große Unterschiede zwischen dem Messwert und dem Energieeintrag zu erwarten (vergleiche FIG 8). Da es sich bei dem System aber um ein deterministisches System handelt, kann auch bei niedrigeren Grundfeldstärken eine solche Übertragungsfunktion bestimmt werden. Letztendlich dient hier das Vibrationsspektrum als Maß für das Streufeld der individuellen Gradientenspule.

Man könnte solche aus der Vibration ermittelten Werte zur Abschaltung der MR-Systems nutzen, wenn der ermittelte Wert einen Schwellwert überschreitet. Dabei kann der besondere Vorteil eines Vibrationssensors, nämlich die schnelle Reaktion, ausgenutzt werden. Es kann also ein hoher Energieeintrag sehr rasch mit den Vibrationssensoren erkannt und eine entsprechende Abschaltung des Systems ausgelöst werden. Die Vibrationsamplitude ist nämlich eine markante Größe des Energietransports. Zumindest bei voll gekoppelten Systemen bildet damit die Amplitude einer sich aufschwingenden Resonanz die Energiedeposition in Echtzeit ab. Mit einer solchen auf Vibrationsmessung basierenden Sensorik könnte also die Sicherheitsmarge zum Schutz des Magneten recht klein gehalten werden und damit den Applikationen deutlich mehr Nutzperformance zur Verfügung gestellt werden.

Prinzipiell könnte, wie oben bereits angedeutet wurde, eine Übertragungsfunktion 17 (d.h. die Übertragung des (Streu-)Felds der Gradientenspule zum Energie- oder Feldeintrag im Heliumkessel oder den Magnetstrukturen) auch mittels Simulation oder Messung einmalig an einem Prototypen oder Vibrationssensoren bestimmt werden. Um den Einfluss des (Streu-)Felds der Gradientenspule auf den Feld- oder Energieeintrag des MR-Systems zu überwachen, könnte der Input des Gradientensignals (z.B. die Ströme des GPA-Signals) verwendet werden. Allerdings würde der Einfluss der individuellen Gradientenspule (d.h. die durch Bautoleranzen bedingten Änderungen des Streufelds) so nicht berücksichtigt werden. Sind Gradientenspulen jedoch so gestaltet, dass das Streufeld klein ist, so ist die aufbaubedingte Änderung des Streufelds mindestens in der Größenordnung der absoluten Größe der einzelnen Streufeldmaxima.

Eine weitere Möglichkeit (welche die individuellen Einflüsse des Aufbaus der Gradientenspule berücksichtigt) wäre, wie erwähnt, die Vibrationen nicht auf dem OVC 3, sondern auf dem Kälteschild 6 zu messen. Da der Transportprozess zum gleichen Teil von der Dynamik des Kälteschilds 6 bestimmt ist, wäre die so ermittelte Übertragungsfunktion näher an der gesuchten Größe. Werden allerdings die Vibrationen des OVC 3 gemessen, so ist ein Austausch defekter Sensoren deutlich leichter als im Fall der Messung der Vibration des Kälteschilds 6. Um einen solchen Defekt zu bestimmen, könnte ein QA-Schritt definiert werden, welcher die Funktionsfähigkeit der Sensoren überprüft (d.h. Antwort der Sensoren auf ein bestimmtes Gradientensignal). Falls dieser QA-Schritt fehlschlägt, müsste ein Servicetechniker den oder die Sensoren austauschen.

FIG 13 zeigt ein schematisches Ausführungsbeispiel eines erfindungsgemäßen Verfahrens zum Überwachen eines Betriebsparameters (insbesondere eines Energieeintrags) für eine Magneteinrichtung eines Magnetresonanzsystems, wobei sich die Magneteinrichtung in einem Außengehäuse und einem darin liegenden Innengehäuse befindet. In einem Schritt S1 wird ein Wert einer Vibrationsamplitude des Außengehäuses oder eines zwischen dem Innengehäuse und dem Außengehäuse liegenden Zwischengehäuses bei einer Vibrationsfrequenz ermittelt. Erfindungsgemäß wird ein gesamtes Vibrationsspektrum ermittelt. In einem Schritt S2, der vor oder nach dem Schritt S1 erfolgen kann, wird ein Übertragungsverhältnis zwischen der Vibrationsamplitude und dem Betriebsparameter bei der Vibrationsfrequenz bereitgestellt. Erfindungsgemäß wird eine gesamte Übertragungsfunktion für einen größeren Frequenzbereich bereitgestellt.

In einem anschließenden Schritt S3 wird ein Wert des Betriebsparameters in Abhängigkeit von dem ermittelten Wert der Vibrationsamplitude mittels des Übertragungsverhältnisses ermittelt. Erfindungsgemäß wird dieser Wert des Betriebsparameters anhand des Vibrationsspektrums und der Übertragungsfunktion ermittelt.

Schließlich kann in einem Schritt S4 das MR-System in Abhängigkeit von dem ermittelten Wert des Betriebsparameters abgeschaltet werden. Insbesondere kann eine Abschaltung erfolgen, wenn der durch die Vibrationen hervorgerufene Energieeintrag in das Innengehäuse einen vorbestimmten Schwellwert überschreitet.

## Patentansprüche

1. Verfahren zum Überwachen eines Betriebsparameters für ein Magnetresonanzsystem umfassend ein Außengehäuse (3), wobei sich in dem Außengehäuse eine elektrisch leitfähige Struktur befindet und die leitfähige Struktur eine Magneteinrichtung oder ein Innengehäuse (5) ist,
- Ermitteln (S1) eines Werts einer Vibrationsamplitude (va) des Außengehäuses (3) oder eines in dem Außengehäuse (3) liegenden Zwischengehäuses (6) bei einer Vibrationsfrequenz (f),
- Bereitstellen (S2) eines Übertragungsverhältnisses (u) zwischen der Vibrationsamplitude (va) und dem Betriebsparameter bei der Vibrationsfrequenz (f) und
- Ermitteln (S3) eines Werts des Betriebsparameters in Abhängigkeit von dem ermittelten Wert der Vibrationsamplitude (va) mittels des Übertragungsverhältnisses (u), wobei der Betriebsparameter entsprechend eine Temperatur des Innengehäuses (5), einen Druck im Innengehäuse (5), einen Energieeintrag in das Innengehäuse (5) oder in die Magneteinrichtung, oder eine von diesen abhängige Größe betrifft,
**dadurch gekennzeichnet, dass**
das Ermitteln des Werts der Vibrationsamplitude (va) im Rahmen eines Ermittelns eines Vibrationsspektrums (18) über mehreren Vibrationsfrequenzen (f) erfolgt, das Bereitstellen des Übertragungsverhältnisses (u) im Rahmen eines Bereitstellens einer Übertragungsfunktion (17) des Betriebsparameters über der Vibrationsfrequenz (f) erfolgt, und das Ermitteln des Werts des Betriebsparameters in Abhängigkeit von dem ermittelten Vibrationsspektrum (18) mittels der Übertragungsfunktion (17, u) erfolgt.

2. Verfahren nach Anspruch 1, wobei das Bereitstellen des Übertragungsverhältnisses (u) oder der Übertragungsfunktion (17) beinhaltet, dass vor Inbetriebnahme des Magnetresonanzsystems der jeweilige Wert des Betriebsparameters bei der jeweiligen Vibrationsfrequenz (f) gemessen oder simuliert wird.

3. Verfahren nach einem der vorhergehenden Ansprüche , wobei die Übertragungsfunktion (17) bezüglich der Vibrationsfrequenz nicht-linear ist.

4. Verfahren nach einem der vorhergehenden Ansprüche , wobei ein Signal der Vibration im Zeitbereich gemessen und zum Ermitteln des Vibrationsspektrums (18) in den Frequenzbereich transformiert wird.

5. Verfahren nach einem der vorhergehenden Ansprüche, wobei der ermittelte Wert des Betriebsparameters mit einem Schwellwert verglichen wird, und in Abhängigkeit von dem daraus resultierenden Vergleichsergebnis das Magnetresonanzsystem abgeschaltet wird (S4).

6. Magnetresonanzsystem mit
- einem Außengehäuse (3),
- einer elektrisch leitfähigen Struktur innerhalb des Au-ßengehäuses (3), wobei die leitfähige Struktur eine Magneteinrichtung oder ein Innengehäuse (5) ist, und
- einer Gradientenspule (2) außerhalb des Außengehäuses (3),
- einer Sensoreinrichtung, die zum Ermitteln eines Werts einer Vibrationsamplitude (va) des Außengehäuses (3) oder eines in dem Außengehäuse (3) liegenden Zwischengehäuses (6) bei einer Vibrationsfrequenz (f) konfiguriert ist und
- einer Überwachungseinrichtung, die zum Bereitstellen eines Übertragungsverhältnisses zwischen der Vibrationsamplitude (va) und einem Betriebsparameter bei der Vibrationsfrequenz (f) und zum Ermitteln eines Werts des Betriebsparameters in Abhängigkeit von dem ermittelten Wert der Vibrationsamplitude (va) mittels des Übertragungsverhältnisses konfiguriert ist, wobei der Betriebsparameter entsprechend eine Temperatur des Innengehäuses (5), einen Druck im Innengehäuse (5), einen Energieeintrag in das Innengehäuse (5) oder in die Magneteinrichtung, oder eine von diesen abhängige Größe betrifft,
**dadurch gekennzeichnet, dass**
das Ermitteln des Werts der Vibrationsamplitude (va) im Rahmen eines Ermittelns eines Vibrationsspektrums (18) über mehreren Vibrationsfrequenzen (f) erfolgt, das Bereitstellen des Übertragungsverhältnisses (u) im Rahmen eines Bereitstellens einer Übertragungsfunktion (17) des Betriebsparameters über der Vibrationsfrequenz (f) erfolgt, und das Ermitteln des Werts des Betriebsparameters in Abhängigkeit von dem ermittelten Vibrationsspektrum (18) mittels der Übertragungsfunktion (17, u) erfolgt.

7. Magnetresonanzsystem nach Anspruch 6, wobei in dem Zwischengehäuse (6) mindestens ein weiteres Zwischengehäuse angeordnet ist.

8. Magnetresonanzsystem nach Anspruch 6 oder 7, wobei die Sensoreinrichtung mindestens zwei Sensoren aufweist, die zwischen der Gradientenspule (2) und dem Außengehäuse (3) oder unmittelbar an der Gradientenspule (2) angeordnet sind.

9. Magnetresonanzsystem nach einem der Ansprüche 6 bis 8, wobei das Außengehäuse (3) eine äußere Vakuumkammer darstellt.

10. Magnetresonanzsystem nach einem der Ansprüche 6 bis 9, wobei das Zwischengehäuse (6) und/oder das weitere Zwischengehäuse (6) ein Kälteschild darstellt.

11. Magnetresonanzsystem nach einem der Ansprüche 6 bis 10, wobei das Innengehäuse (5) als eine Heliumkammer oder ein Rohrsystem ausgestaltet ist, oder die Magneteinrichtung als supraleitende Spule ausgestaltet ist.

## Claims

1. Method for monitoring an operating parameter for a magnetic resonance system comprising an outer housing (3), wherein an electrically conductive structure is located in the outer housing and the conductive structure is a magnet device or an inner housing (5),
- determining (S1) a value of a vibration amplitude (va) of the outer housing (3) or an intermediate housing (6) located in the outer housing (3) at a vibration frequency (f),
- providing (S2) a transmission ratio (u) between the vibration amplitude (va) and the operation parameter at the vibration frequency (f) and
- determining (S3) a value of the operating parameter as a function of the determined value of the vibration amplitude (va) by means of the transmission ratio (u), wherein the operating parameter correspondingly relates to a temperature of the inner housing (5), a pressure in the inner housing (5), an energy input into the inner housing (5) or into the magnet device, or a variable dependent thereon,
**characterised in that**
the value of the vibration amplitude (va) is determined as part of determining a vibration spectrum (18) over a plurality of vibration frequencies (f), the transmission ratio (u) is provided as part of providing a transmission function (17) of the operating parameter over the vibration frequency (f) and the value of the operating parameter is determined as a function of the determined vibration spectrum (18) by means of the transmission function (17, u).

2. Method according to claim 1, wherein providing the transmission ratio (u) or the transmission function (17) involves the respective value of the operating parameter being measured or simulated at the respective vibration frequency (f) before commissioning of the magnetic resonance system.

3. Method according to one of the preceding claims, wherein the transmission function (17) is non-linear with respect to the vibration frequency.

4. Method according to one of the preceding claims, wherein a signal of the vibration in the time range is measured and, to determine the vibration spectrum (18), is transformed into the frequency range.

5. Method according to one of the preceding claims, wherein the determined value of the operating parameter is compared with a threshold value, and the magnetic resonance system is switched off (S4) as a function of the resulting comparative result.

6. Magnetic resonance system having
- an outer housing (3),
- an electrically conductive structure within the outer housing (3), wherein the conductive structure is a magnet device or an inner housing (5), and
- a gradient coil (2) outside the outer housing (3),
- a sensor device, which is configured to determine a value of a vibration amplitude (va) of the outer housing (3) or an intermediate housing (6) located in the outer housing (3) at a vibration frequency (f) and
- a monitoring device, which is configured to provide a transmission ratio between the vibration amplitude (va) and an operating parameter at the vibration frequency (f) and to determine a value of the operating parameter as a function of the determined value of the vibration amplitude (va) by means of the transmission ratio, wherein the operating parameter correspondingly relates to a temperature of the inner housing (5), a pressure in the inner housing (5), an energy input into the inner housing (5) or into the magnet device, or a variable dependent thereon,
**characterised in that**
the value of the vibration amplitude (va) is determined as part of determining a vibration spectrum (18) over a plurality of vibration frequencies (f), the transmission ratio (u) is provided as part of providing a transmission function (17) of the operating parameter over the vibration frequency (f) and the value of the operating parameter is determined as a function of the determined vibration spectrum (18) by means of the transmission function (17, u).

7. Magnetic resonance system according to claim 6, wherein at least one further intermediate housing is arranged in the intermediate housing (6).

8. Magnetic resonance system according to claim 6 or 7, wherein the sensor device has at least two sensors, which are arranged between the gradient coil (2) and the outer housing (3) or directly on the gradient coil (2).

9. Magnetic resonance system according to one of claims 6 to 8, wherein the outer housing (3) constitutes an outer vacuum chamber.

10. Magnetic resonance system according to one of claims 6 to 9, wherein the intermediate housing (6) and/or the further intermediate housing (6) constitutes a cold shield.

11. Magnetic resonance system according to one of claims 6 to 10, wherein the inner housing (5) is designed as a helium chamber or a pipe system, or the magnet device is designed as a superconducting coil.

## Revendications

1. Procédé de contrôle d'un paramètre de fonctionnement d'un système à résonance magnétique comprenant un boîtier (3) extérieur, dans lequel une structure conductrice de l'électricité se trouve dans le boîtier extérieur et la structure conductrice est un dispositif magnétique ou un boîtier (5) intérieur,
- détermination (S1) d'une valeur d'une amplitude (va) de vibration du boîtier (3) extérieur ou d'un boîtier (6) intermédiaire se trouvant dans le boîtier (3) extérieur à une fréquence (f) de vibration,
- mise à disposition (S2) d'un rapport (u) de transfert entre l'amplitude (va) de vibration et le paramètre de fonctionnement à la fréquence (f) de vibration et
- détermination (S3) d'une valeur du paramètre de fonctionnement en fonction de la valeur déterminée de l'amplitude (va) de vibration au moyen du rapport (u) de transfert, dans lequel le paramètre de fonctionnement concerne une température du boîtier (5) intérieur, une pression dans le boîtier (5) intérieur, un apport d'énergie au boîtier (5) intérieur ou au dispositif magnétique, où une grandeur dépend de ceux-ci,
**caractérisé en ce que**
la détermination de la valeur de l'amplitude (va) de vibration s'effectue dans le cadre d'une détermination d'un spectre (18) de vibration sur plusieurs fréquences (f) de vibration, la mise à disposition du rapport (u) de transfert s'effectue dans le cadre d'une mise à disposition d'une fonction (17) de transfert du paramètre de fonctionnement sur la fréquence (f) de vibration et la détermination de la valeur du paramètre de fonctionnement, en fonction du spectre (18) de vibration déterminé s'effectue au moyen de la fonction (17, u) de transfert.

2. Procédé suivant la revendication 1, dans lequel la mise à disposition du rapport (u) de transfert ou de la fonction (17) de transfert comporte que l'on mesure ou on simule, avant la mise en fonctionnement du système à résonance magnétique, la valeur respective du paramètre de fonctionnement à la fréquence (f) de vibration respective.

3. Procédé suivant l'une des revendications précédentes, dans lequel la fonction (17) de transfert est non linéaire rapportée à la fréquence de vibration.

4. Procédé suivant l'une des revendications précédentes, dans lequel on mesure un signal de la vibration dans le domaine temporel et on le transforme dans le domaine fréquentiel pour la détermination du spectre (18) de vibration.

5. Procédé suivant l'une des revendications précédentes, dans lequel on compare la valeur déterminée du paramètre de fonctionnement à une valeur de seuil, et on arrête (S4) le système à résonance magnétique en fonction du résultat de la comparaison qui s'ensuit.

6. Système à résonance magnétique comprenant
- un boîtier (3) extérieur,
- une structure conductrice électrique à l'intérieur du boîtier (3) extérieur, la structure conductrice étant un dispositif magnétique ou un boîtier (5) intérieur et,
- une bobine (2) de gradient à l'extérieur du boîtier (3) extérieur,
- un dispositif capteur, qui est configuré pour la détermination d'une valeur d'une amplitude (va) de vibration du boîtier (3) extérieur ou d'un boîtier (6) intermédiaire se trouvant dans le boîtier (3) extérieur à une fréquence (f) de vibration et
- un dispositif de contrôle, qui est configuré pour donner un rapport de transfert entre l'amplitude (va) de vibration et un paramètre de fonctionnement à la fréquence (f) de vibration et pour déterminer une valeur du paramètre de fonctionnement en fonction de la valeur déterminée de l'amplitude (va) de vibration au moyen du rapport de transfert,
dans lequel le paramètre de fonctionnement concerne une température du boîtier (5) intérieur, une pression dans le boîtier (5) intérieur, un apport d'énergie au boîtier (5) intérieur ou au dispositif magnétique ou une grandeur qui en dépend,
**caractérisé en ce que**
la détermination de la valeur de l'amplitude (va) de vibration s'effectue dans le cadre d'une détermination d'un spectre (18) de vibration sur plusieurs fréquences (f) de vibration, la mise à disposition du rapport (u) de transfert s'effectue dans le cadre d'une mise à disposition d'une fonction (17) de transfert du paramètre de fonctionnement sur la fréquence (f) de vibration et la détermination de la valeur du paramètre de fonctionnement en fonction du spectre (18) de vibration déterminé s'effectue au moyen de la fonction (17, u) de transfert.

7. Système à résonance magnétique suivant la revendication 6, dans lequel au moins un autre boîtier intermédiaire est disposé dans le boîtier (6) intermédiaire.

8. Système à résonance magnétique suivant la revendication 6 ou 7, dans lequel le dispositif capteur a au moins deux capteurs, qui sont disposés entre la bobine (2) de gradient et le boîtier (3) extérieur ou directement sur la bobine (2) de gradient.

9. Système à résonance magnétique suivant l'une des revendications 6 à 8, dans lequel le boîtier (3) extérieur représente une chambre extérieure sous-vide.

10. Système à résonance magnétique suivant l'une des revendications 6 à 9, dans lequel le boîtier (6) intermédiaire et/ou l'autre boîtier (6) intermédiaire représente un écran au froid.

11. Système à résonance magnétique suivant l'une des revendications 6 à 10, dans lequel le boîtier (5) intérieur est conformé en chambre à hélium ou en système tubulaire où le dispositif magnétique est conformé en bobine supraconductrice.
